# EUROPÄISCHE PATENTSCHRIFT

(11) **EP 1 103 857 B1**
(45) Veröffentlichungstag und Bekanntmachung des Hinweises auf die Patenterteilung: **20.09.2006**
(21) Anmeldenummer: 00123292.5
(22) Anmeldetag: 27.10.2000
(51) Int. Cl.: G03F 7/20, G02B 7/02, G02B 7/18, G02B 13/14

(54) **Optische Anordnung**
Optical system
Système optique

(30) Priorität: 24.11.1999 DE 19956353
(43) Veröffentlichungstag der Anmeldung: 30.05.2001
(73) Patentinhaber: Carl Zeiss SMT AG, 73446 Oberkochen (DE)
(72) Erfinder: Xalter, Stefan, 73447 Oberkochen (DE); Becker, Jochen, 73447 Oberkochen (DE); Bünau, Rudolf von, 73457 Essingen (DE); Wagner, Christian, 73430 Aalen (DE); Müller-Rissmann, Werner, 73447 Oberkochen (DE); Hummel, Wolfgang, 73525 Schwäbisch-Gmünd (DE); Holderer, Hubert, 89551 Königsbronn (DE)
(74) Vertreter: Ostertag, Ulrich

(56) Entgegenhaltungen:
- EP-A- 0 678 768
- EP-A- 0 938 009
- US-A- 4 730 900
- US-A- 5 920 377

## Beschreibung

Die Erfindung betrifft eine optische Anordnung, insbesondere eine Projektions-Belichtungsanlage der Mikrolithographie, insbesondere mit schlitzförmigem Bildfeld oder nicht rotationssymmetrischer Beleuchtung, mit einer Lichtquelle, die Strahlung emittiert, einem refraktiven optischen Element, das durch nicht rotationssymmetrische Beaufschlagung mit der Strahlung erwärmt wird, und mindestens einem an das optische Element gekoppelten elektrischen Heizelement, sowie eine Heizstromquelle.

Die Abbildungsqualität einer derartigen optischen Anordnung wird oftmals durch nicht rotationssymmetrische Abbildungsfehler gemindert. Derartige Abbildungsfehler entstehen z. B. außer durch nicht rotationssymmetrische lichtinduzierte Erwärmung des optischen Elements auch durch andere lichtinduzierte Effekte wie z.B. "compaction", die eine entsprechende nicht rotationssymmetrische Ausdehnung bzw. Brechungsindexverteilung im optischen Element zur Folge haben.

Bei hohen Anforderungen an die Abbildungsqualität, wie sie insbesondere bei Projektions-Belichtungsverfahren in der Mikrolithographie gefordert sind, können die beschriebenen lichtinduzierten Abbildungsfehler nicht toleriert werden. Aus der EP 0 678 768 A2 ist es bekannt, über eine Symmetrisierung bzw. Homogenisierung der Temperaturverteilung durch eine zusätzliche Beheizung eine Verbesserung der Abbildungseigenschaften anzustreben. Hierzu sind mehrere Heizelemente an die Umfangsfläche einer Linse thermisch angekoppelt und beheizen dadurch diese Linse vom Rand her.

Aus der DE 198 27 602 A1 ist eine Anordnung zur Homogenisierung der Temperaturverteilung eines optischen Elements mit im Bereich der Umfangsfläche angekoppelten Peltierelementen bekannt, die das optische Element wahlweise kühlen oder heizen.

Eine derartige Beheizung bzw. Kühlung der Linse hat den Nachteil, daß die Umfangsfläche der Linse relativ stark beheizt bzw. gekühlt werden muß, um trotz der in der Regel schlechten Wärmeleitungseigenschaften des Linsenmaterials im für die Abbildungseigenschaften meist relevanten Zentralbereich der Linse eine derartige Symmetrisierung bzw. Homogenisierung der Temperaturverteilung zu erreichen. Eine starke Erwärmung oder Kühlung im Umfangsbereich der Linse führt jedoch zur Gefahr einer Beschädigung der Linse und/oder der Linsenfassung durch thermische Spannungen.

Weiterhin ist aus der DE 198 07 094 A1 eine Anordnung bekannt, bei der am Umfang eines zur Projektionsoptik einer Projektionsbelichtungsanlage gehörenden optischen Elements Verbindungsstrukturen zur passiven Wärmeableitung angebracht sind. Da hier auf aktive Wärmezu- oder -abfuhr verzichtet wird, sind die Möglichkeiten zur Homogenisierung der Temperaturverteilung relativ eingeschränkt.

Aufgrund des relativ großen Abstands zwischen dem Umfangsbereich und dem Zentralbereich der Linse ist bei den genannten Anordnungen eine gezielte strukturierte Beeinflussung der Temperaturverteilung in der Umgebung des Zentralbereichs praktisch kaum möglich.

Aus der EP 0 532 236 B1 ist eine Anordnung zur Beheizung und Kühlung eines Spiegelkörpers in einer Projektionsbelichtungsanlage bekannt.

Aufgabe der vorliegenden Erfindung ist es, eine optische Anordnung der eingangs genannten Art derart weiterzubilden, daß eine bessere Symmetrisierung bzw. Homogenisierung der Temperaturverteilung im optischen Element erreicht werden kann.

Diese Aufgabe wird erfindungsgemäß dadurch gelöst, daß das Heizelement umfaßt: eine vom optischen Element getragene Widerstands-Heizbeschichtung, die im Bereich der durch die Strahlung der Lichtquelle beaufschlagten Fläche des optischen Elements im wesentlichen optisch transparent ist und mehrere parallel angeordnete, voneinander elektrisch isolierte Beschichtungsstreifen aufweist.

Mit einem Heizelement, das derart angeordneten Beschichtungsstreifen aufweist, ist eine gute Anpassung der Abbildungseigenschaften über die aufgrund der zusätzlichen Heizung insgesamt sich ergebende Temperaturverteilung im Linsenkörper möglich. Insbesondere können der Zentralbereich des Linsenkörpers und seine Umgebung, deren nicht rotationssymmetrische Erwärmung durch Restabsorption der /p Strahlung der Lichtquelle primär zu auftretendem Abbildungsfehlern der Linse beiträgt, direkt beheizt werden. Da die Beschichtungsstreifen optisch transparent sind, wird durch diese die Apertur der Linse nicht unnötig begrenzt. Dasselbe Heizelement kann daher auch bei wechselnden durch die Strahlung der Lichtquelle beaufschlagten Flächen des Linsenkörpers eingesetzt werden.

Die Beschichtungsstreifen können eine das optische Element insbesondere im Umgebungsbereich der durch die Strahlung der Lichtquelle beaufschlagten Fläche im wesentlichen bedeckende Schicht bilden, wobei zwischen den einzelnen Beschichtungsstreifen nur schmale Zwischenräume verbleiben. Eine derartige Anordnung der Beschichtungsstreifen ermöglicht eine praktisch lückenlose Beheizung der Linsenoberfläche insbesondere im Umgebungsbereich der durch die Strahlung der Lichtquelle beaufschlagten Fläche. Dadurch ist eine gute Kontrolle der Abbildungseigenschaften über die durch die Beheizung einstellbare Temperaturverteilung im optischen Element möglich. Die schmalen Zwischenräume zwischen den Beschichtungsstreifen dienen der elektrischen Isolation zwischen diesen.

Die Beschichtungsstreifen können auf ihrer vom optischen Element abgewandten Seite eine Antireflexschicht tragen. Diese Antireflexschicht stellt gleichzeitig eine Schutzschicht für die Beschichtungsstreifen dar. Insbesondere bei Beschichtungsstreifen aus einem Material mit einem Brechungsindex, der größer ist als der des Materials, aus dem das optische Element gefertigt ist, lassen sich erhöhte Reflexionsverluste an der vom optischen Element abgewandten Grenzfläche der Beschichtungsstreifen vermeiden.

Vorzugsweise ist die Antireflexschicht eine durchgängige Schicht auf dem optischen Element. So können z.B. sowohl die Beschichtungsstreifen als auch die Antireflexschicht durch zwei aufeinanderfolgende Bedampfungs- oder sonstige Beschichtungsvorgänge auf einfache Weise aufgebracht werden.

Die Beschichtungsstreifen sind bevorzugt aus einem Material gefertigt, das im Bereich der Wellenlänge der Strahlung im wesentlichen den gleichen Brechungsindex wie das Material des optischen Elements aufweist. Dadurch werden Reflexionsverluste an der Grenzfläche zwischen den Beschichtungsstreifen und dem Linsenkörper vermieden.

Mindestens zwei Beschichtungsstreifen können voneinander verschiedene elektrische Widerstände pro Längeneinheit aufweisen. Bei gegebenem Heizstrom steigt die Heizleistung mit dem Heizwiderstand. Durch die Vorgabe entsprechender Widerstände pro Längeneinheit kann bei konstantem Heizstrom schon eine Heizleistungsverteilung über die Linsenfläche erzielt werden, die zu einer guten Symmetrisierung bzw. Homogenisierung der Temperaturverteilung im Linsenkörper führt. Eine Stromregelung des Heizstroms kann dann entfallen.

Wenn die Beschichtungsstreifen aus mehreren Bereichen mit unterschiedlichem elektrischem Widerstand pro Längeneinheit bestehen, ist noch ein zusätzlicher Freiheitsgrad bei der Anpassung der Heizleistungsverteilung über die Fläche des Linsenkörpers gegeben, ohne daß dazu eine Variation des Heizstroms erforderlich ist.

Längs der Beschichtungsstreifen kann ein stetiger Übergang des elektrischen Widerstands pro Längeneinheit erfolgen. Ein derart stetiger Übergang hat eine entsprechend stetige Änderung der über die Länge des Beschichtungsstreifens abgegebenen Heizenergie zur Folge. Unerwünschte Sprünge in der Temperaturverteilung werden dadurch vermieden.

Bei einer bevorzugten Ausführungsform sind die Beschichtungsstreifen spiegelsymmetrisch zu einer Meridional-Symmetrieebene, die parallel zu den Beschichtungsstreifen liegt, angeordnet. Dadurch wird bei einer Strahlungsleistungsverteilung der Beaufschlagung durch die Lichtquelle, die ebenfalls eine Spiegelsymmetrie aufweist, die Anpassung der Heizleistung zur Erzeugung einer symmetrischen bzw. homogenen Temperaturverteilung erleichtert.

Wenn die durch die Meridional-Symmetrieebene einander spiegelsymmetrisch zugeordneten Beschichtungsstreifen gleiche elektrische Widerstände aufweisen, wird die Herstellung des Heizelements vereinfacht.

Bei einer bevorzugten Ausführungsform der Erfindung weist die Heizstromquelle mindestens zwei elektrische Versorgungseinrichtungen auf und die durch die Meridional-Symmetrieebene einander spiegelsymmetrisch zugeordneten Beschichtungsstreifen werden durch dieselbe elektrische Versorgungseinrichtung beheizt. Dies vereinfacht die Ansteuerung des Heizelements.

Die Heizstromquelle kann in Signalverbindung mit einer Heizstromsteuerschaltung stehen, die die von den elektrischen Versorgungseinrichtungen abzugebenden Leistungen vorgibt. Dies ermöglicht eine automatische Anpassung der Verteilung der Heizleistung an die Änderung äußerer Betriebsparameter der Projektions-Belichtungsanlage.

Bevorzugt steht die Heizstromsteuerschaltung in Signalverbindung mit einem die Abbildungseigenschaften des optischen Elements und/oder der optischen Anordnung messenden Sensor und die Vorgabe der an die elektrischen Versorgungseinrichtungen abzugebenden Leistungen erfolgt in Anhängigkeit vom Meßergebnis des Sensors. Eine derartige Anordnung ermöglicht die automatische Anpassung der Heizleistungsverteilung zur Optimierung der vom Sensor erfaßten Abbildungseigenschaften des optischen Elements und/oder der gesamten optischen Anordnung.

Der Sensor kann ein positionsempfindlicher Sensor sein, der in einer Bildebene des optischen Elements und/oder der optischen Anordnung angeordnet ist. Mit einem derartigen Sensor ist eine präzise Erfassung der Abbildungseigenschaften des optischen Elements und/oder der op-tischen Anordnung möglich.

Der positionsempfindliche Sensor kann ein CCD-Detektor sein. Ein derartiger Sensor hat eine hohe optische Empfindlichkeit und eine gute Linearität.

Ein Ausführungsbeispiel der Erfindung wird nachfolgend anhand der Zeichnung näher erläutert; es zeigen:
- Figur 1:: eine Aufsicht auf eine erfindungsgemäß heizbare Seite einer Linse, wobei die elektrische Versorgungs- und Ansteuerungsschaltung der Heizung als Blockschaltbild gezeigt ist;
- Figur 2:: einen Schnitt durch die heizbare Linse gemäß Linie II-II von Figur 1.

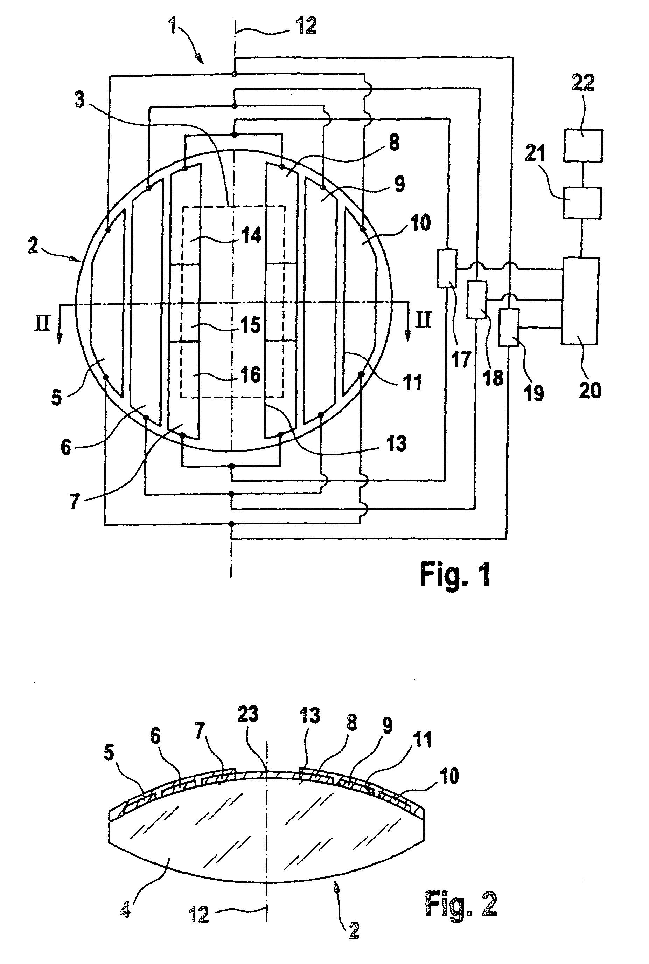

Eine in der Zeichnung dargestellte heizbare Linse 1 ist Teil der optischen Anordnung einer Projektions-Belichtungsanlage der Mikrolithographie, deren weitere Bauteile in der Zeichnung nicht dargestellt sind. Ein Linsenkörper 2 wird dabei mit einem Projektions-Lichtbündel einer Lichtquelle, z.B. dem UV-Emissionsbündel eines Argon-Fluorid-Excimerlasers beaufschlagt. Dieses weist dort, wo es den Linsenkörper 2 durchdringt, eine rechteckige Querschnittsfläche auf, die in Figur 1 durch ein gestricheltes Rechteck 3 angedeutet ist. Eine derartige Belichtungsgeometrie führt zu einem schlitzförmigen Bildfeld der Projektions-Belichtungsanlage.

Der Linsenkörper 2 weist einen runden, bikonvexen (vgl. Figur 2) Grundkörper 4 auf, der auf seiner nach oben zeigenden Fläche mit insgesamt sechs Widerstandsstreifen 5 bis 10 beschichtet ist. Der Grundkörper 4 besteht aus einem gut für das Projektions-Lichtbündel durchlässigen Material, im Falle eines UV-Emissionsbündels z.B. aus Quarzglas oder CaF₂.

Die Widerstandsstreifen 5 bis 10 sind parallel zueinander in zwei Gruppen zu je drei Widerstandsstreifen 5, 6, 7 bzw. 8, 9, 10 angeordnet, wobei zwischen den einzelnen Widerstandsstreifen innerhalb einer Gruppe (5, 6, 7 bzw. 8, 9, 10) jeweils ein schmaler Isolationsspalt 11 verbleibt.

Die beiden Gruppen von Widerstandsstreifen 5, 6, 7 bzw. 8, 9, 10 sind symmetrisch bezüglich einer parallel zwischen ihnen verlaufenden Meridionalebene 12 des Linsenkörpers 2 angeordnet. Zwischen den der Meridionalebene 12 benachbarten Widerstandsstreifen 7, 8 verbleibt ein verglichen mit den Isolationsspalten 11 größerer Zwischenraum 13, in dem der Grundkörper 4 keine Heizbeschichtung aufweist.

Die Widerstandsstreifen 5 bis 10 bestehen aus einem für die Wellenlänge der Lichtquelle (im Falle des Argon-Fluorid-Excimerlasers 193,3 nm) optisch praktisch verlustfrei transparenten elektrisch leitfähigen Medium. Ihre Längsausdehnung ist durch die runde Form des Linsenkörpers 2 begrenzt, so daß die innersten Widerstandsstreifen 7, 8 die längsten und die äußersten Widerstandsstreifen 5, 19 die kürzesten Streifen sind.

Die beiden innersten Widerstandsstreifen 7, 8 sind senkrecht zu ihrer Längserstreckung jeweils in drei Widerstandsbereiche 14 bis 16 unterteilt. Der zentrale Widerstandsbereich 15 hat verglichen mit den ihn umgebenden äußeren Widerstandbereichen 14 und 16 einen geringeren elektrischen Widerstand pro Längeneinheit längs der Widerstandsstreifen 7 bzw. 8.

Der größere Widerstand pro Längeneinheit der Widerstandsbereiche 14 und 16, verglichen mit dem Widerstandsbereich 15, wird dadurch erzielt, daß die Schichtdicke des Widerstandsstreifens 7 im Widerstandsbereich 15 größer ist als in den Widerstandbereichen 14 und 16. Alternativ kann dies auch durch eine entsprechende Materialauswahl in den Widerstandsbereichen 14 bis 16 erreicht werden, z.B. durch eine in den Widerstandsbereichen 14 und 16 geringere Dotierung mit einem leitfähigen Material als im Widerstandsbereich 15. Der Widerstand pro Längeneinheit der Widerstandsstreifen 5, 6 bzw. 9, 10 entspricht demjenigen der Widerstandsbereiche 14, 16.

Durch die beschriebene Anordnung der Widerstandsstreifen 5 bis 10 zur Meridionalebene 12 ergeben sich drei Paare 7, 8; 6, 9; 5, 10 von Widerstandsstreifen, die jeweils aus zwei symmetrisch zueinander angeordneten Widerstandsstreifen bestehen. Die Widerstandsstreifen 5 bis 10 weisen an ihren schmalen Seiten, die dem Rand des Linsenkörpers 2 benachbart sind, Kontaktstellen auf, über die elektrische Leitungen an die Widerstandsstreifen 5 bis 10 angeschlossen sind. Die Paare 7, 8; 6, 9; 5, 10 sind elektrisch parallel geschaltet. Jedes Paar 7, 8; 6, 9; 5, 10 ist an ein eigenes Netzteil 17, 18, 19 angeschlossen. Dieses versorgt die entsprechenden Widerstandsstreifen 5 bis 10 zum Heizen mit elektrischer Energie.

Die elektrische Leistungsabgabe der Netzteile 17 bis 19 wird von einer Heizstromsteuerschaltung 20 gesteuert, die in Signalverbindung mit diesen steht. Die Soll-Leistung für die Netzteile 17 bis 19 wird der Heizstromsteuerschaltung 20 von einer Belichtungssteuerungsschaltung 21 vorgegeben, die mit der Heizstromsteuerschaltung 20 in Signalverbindung steht. Mit der Belichtungssteuerungsschaltung 21 wiederum ist ein zweidimensionales CCD-Array 22 verbunden, auf das mit einem entsprechenden optischen Element (nicht dargestellt) eine Bildebene der optischen Anordnung der Projektionsbelichtungsanlage abgebildet wird.

In Figur 2 ist gezeigt, daß der Grundkörper 4 des Linsenkörpers 2 auf der Seite, auf der er die Widerstandsstreifen 5 bis 10 trägt, mit einer Antireflex-Schicht 23 beschichtet ist. Diese ist, vor allem was ihre Stärke oberhalb der Widerstandsstreifen 5 bis 10 und im Bereich der Isolationsspalte 11 bzw. des Zwischenraums 13 betrifft, nur schematisch dargestellt.

Auch die von den Widerstandsstreifen 5 bis 10 abgewandte Seite des Linsenkörpers 2 trägt eine Antireflex-Schicht (nicht dargestellt).

Die heizbare Linse funktioniert folgendermaßen:

Durch das Projektions-Lichtbündel wird der Linsenkörper 2 aufgrund der Restabsorption, die das Material des Linsenkörpers 2 im Bereich der Wellenlänge des Projektions-Lichtbündels aufweist, erwärmt. Diese Erwärmung hat zunächst die Symmetrie des Lichtkanals des Projektions-Lichtbündels im Linsenkörper 2. Sie führt sowohl zu einer thermischen Ausdehnung des Materials als auch zu einer Brechungsindexänderung und daher zu einer Änderung der Abbildungseigenschaften des Linsenkörpers 2.

Ziel der Heizung des Linsenkörpers 2 mit den Widerstandsstreifen 5 bis 10 ist es, eine Symmetrisierung bzw. eine vorgegebene Form der Temperaturverteilung in dem Linsenkörper 2 zu erreichen. Die daraus resultierende definierte Verteilung der thermischen Ausdehnung sowie der räumlich konstante Brechungsindex im Linsenkörper 2 führen zu kontrollierbaren Abbildungseigenschaften.

Mittels der Heizstromsteuerschaltung 20 wird in einem ersten Schritt die Leistungsabgabe der Netzteile 17 bis 19 an die Widerstandsstreifen 5 bis 10 so angesteuert, daß diese den Linsenkörper 2, insbesondere den Grundkörper 4 überwiegend dort beheizen, wo keine Erwärmung durch das Projektions-Lichtbündel auftritt. Dies sind in der in Figur 1 dargestellten Situation, bei der die Querschnittsfläche 3 des Projektions-Lichtbündels nur die Widerstandsstreifen 7, 8 teilweise durchdringt, die Widerstandsstreifen 5, 6 bzw. 9, 10.

Die kombinierte Erwärmung des Linsenkörpers 2 durch die Beaufschlagung mit dem Projektions-Lichtbündel einerseits und die elektrische Heizung der Widerstandsstreifen 5, 6, 9, 10 andererseits führt zu einer Temperaturverteilung im Linsenkörper 2, die einer Rotationssymmetrie um die optische Achse näher kommt als in dem Fall eines unbeheizten Linsenkörpers 2, der nur über die Restabsorption des Projektion-Lichtbündels erwärmt wird. Diese verbesserte Symmetrisierung der Temperaturverteilung hat eine Verringerung von Abbildungsfehlern des Linsenkörpers 2 zur Folge. Diese geringeren Abbildungsfehler führen zu einer verbesserten Abbildung der Projektions-Belichtungsanlage, was wiederum vom CCD-Array 22 erfaßt und mit Hilfe der Belichtungssteuerungsschaltung 21 mittels bekannter Bilderfassungs-Algorithmen ausgewertet wird.

Durch Vergleich der vom CCD-Array 22 erfaßten momentan mittels der Projektion-Belichtungsanlage abgebildeten Struktur mit einer der Belichtungssteuerungsschaltung 21 vorgegebenen Soll-Struktur ermittelt die Belichtungssteuerungsschaltung 21 neue Soll-Werte für die Leistungsabgabe der Netzteile 17 bis 19, die an die HeizstromSteuerschaltung 20 zur Ansteuerung der Netzteile 17 bis 19 weitergegeben werden. Auf diese Weise nähert sich die Abbildungsqualität der optischen Anordnung durch die flächenselektive Beheizung der heizbaren Linse 1 iterativ einem Optimum mit minimalen Abbildungsfehlern an.

Abhängig von der Bildebene, die vom CCD-Array 22 überwacht wird, ist eine Optimierung von Abbildungseigenschaften der Linse 1 alleine oder einer Linsengruppe, zu der die Linse 1 gehört, z.B. eines Projektionsobjektivs möglich. In den letzten beiden Fällen erfolgt eine Überkompensation von Abbildungsfehlern, indem die eine heizbare Linse 1 derart beheizt wird, daß die dadurch resultierenden Abbildungseigenschaften der Linse 1 die Abbildungsfehler der restlichen Linsen einer Linsengruppe gerade kompensiert.

Werden auch die Heizstreifen 7, 8 im Zuge dieses Iterationsprozesses durch das Netzteil 17 mit Heizstrom beaufschlagt, sorgt der geringere Widerstand pro Längeneinheit der mittleren Widerstandsbereiche 15 im Vergleich zu den diesen benachbarten Widerstandsbereichen 14, 16 dafür, daß der Bereich des Linsenkörpers 2, der der optischen Achse benachbart ist und vom Projektions-Lichtbündel, das dort im Regelfall am intensivsten ist, am stärksten erwärmt wird, nicht noch zusätzlich eine stärkere Erwärmung durch die Widerstandsheizung erfährt.

Die Anordnung der Widerstandsbereiche 14 bis 16 ist in Figur 1 nur exemplarisch. In der Praxis können die Widerstandsstreifen 5 bis 10 auch beidseitig des Linsenkörpers 2 angeordnet oder auch in eine Vielzahl von Widerstandsbereichen mit unterschiedlichem Heizwiderstand unterteilt sein. Dabei können sich zur Anpassung der Heizleistung an die Geometrie der Lichtbeaufschlagung sowohl die absoluten als auch die Widerstände pro Längeneinheit der Widerstandsstreifen 5 bis 10 voneinander unterscheiden. Die Übergänge der Widerstände pro Längeneinheit zwischen den einzelnen Widerstandsbereichen müssen nicht scharf, sondern können auch fließend sein.

Durch die oben beschriebene Widerstandsheizung ist nicht nur ein Ausgleich restabsorptionsbedingter Abbildungsfehler möglich, auch andere Abbildungsfehler, z.B. Astigmatismen oder durch Materialinhomogenitäten in den optischen Elementen verursachte Fehler, können durch eine entsprechende Beheizung über Widerstandsstreifen kompensiert werden.

## Patentansprüche

1. Optische Anordnung mit einer Lichtquelle, die Strahlung emittiert, einem refraktiven optischen Element, das durch nicht rotationssymmetrische Beaufschlagung mit der Strahlung erwärmt wird, mindestens einem an das optische Element gekoppelten elektrischen Heizelement sowie einer Heizstromquelle (17 bis 19),
**dadurch gekennzeichnet, daß**
das Heizelement umfaßt: eine vom optischen Element (4) getragene Widerstands-Heizbeschichtung, die im Bereich der durch die Strahlung der Lichtquelle beaufschlagten Fläche (3) des optischen Elements (4) im wesentlichen optisch transparent ist und mehrere parallel angeordnete, voneinander elektrisch isolierte Beschichtungsstreifen (5 bis 10) aufweist.

2. Optische Anordnung nach Anspruch 1, **dadurch gekennzeichnet, daß** die Beschichtungsstreifen (5 bis 10) eine das optische Element (4) insbesondere im Umgebungsbereich der durch die Strahlung der Lichtquelle beaufschlagten Fläche (3) im wesentlichen bedeckende Schicht bilden, zwischen den einzelnen Beschichtungsstreifen (5 bis 10) nur schmale Zwischenräume (11) verbleiben.

3. Optische Anordnung nach Anspruch 1 oder 2, **dadurch gekennzeichnet, daß** die Beschichtungsstreifen (5 bis 10) auf ihrer vom optischen Element (4) abgewandten Seite eine Antireflexschicht (23) tragen.

4. Optische Anordnung nach Anspruch 3, **dadurch gekennzeichnet, daß** die Antireflexschicht (23) eine durchgängige Schicht auf dem optischen Element (4) ist.

5. Optische Anordnung nach einem der vorhergehenden Ansprüche, **dadurch gekennzeichnet, daß** die Beschichtungsstreifen (5 bis 10) aus einem Material gefertigt sind, das im Bereich der Wellenlänge der Strahlung im wesentlichen den gleichen Brechungsindex wie das Material des optischen Elements (4) aufweist.

6. Optische Anordnung nach einem der vorhergehenden Ansprüche, **dadurch gekennzeichnet, daß** mindestens zwei Beschichtungsstreifen (5 bis 10) voneinander verschiedene elektrische Widerstände pro Längeneinheit aufweisen.

7. Optische Anordnung nach einem der vorhergehenden Ansprüche, **dadurch gekennzeichnet, daß** die Beschichtungsstreifen (7, 8) aus mehreren Bereichen (14, 15, 16) mit unterschiedlichem elektrischem Widerstand pro Längeneinheit bestehen.

8. Optische Anordnung nach Anspruch 7, **dadurch gekennzeichnet, daß** zwischen den Bereichen (14, 15, 16) längs der Beschichtungsstreifen (7, 8) ein stetiger Übergang des elektrischen Widerstands pro Längeneinheit erfolgt.

9. Optische Anordnung nach einem der vorhergehenden Ansprüche, **dadurch gekennzeichnet, daß** die Beschichtungsstreifen (5 bis 10) spiegelsymmetrisch zu einer Meridional-Symmetrieebene (12), die parallel zu den Beschichtungsstreifen (5 bis 10) liegt, angeordnet sind.

10. Optische Anordnung nach Anspruch 9, **dadurch gekennzeichnet, daß** die durch die Meridional-Symmetrieebene (12) einander spiegelsymmetrisch zugeordneten Beschichtungsstreifen (7, 8; 6, 9; 5, 10) gleiche elektrische Widerstände aufweisen.

11. Optische Anordnung nach einem der vorhergehenden Ansprüche, **dadurch gekennzeichnet, daß** die Heizstromquelle mindestens zwei elektrische Versorgungseinrichtungen (17 bis 19) aufweist und daß die durch die Meridional-Symmetrieebene (12) einander spiegelsymmetrisch zugeordneten Beschichtungsstreifen (7, 8; 6, 9; 5, 10) durch dieselbe elektrische Versorgungseinrichtung (17; 18; 19) beheizt werden.

12. Optische Anordnung nach einem der vorhergehenden Ansprüche, **dadurch gekennzeichnet, daß** die Heizstromquelle (17 bis 19) in Signalverbindung mit einer Heizstromsteuerschaltung (20) steht, die die von den elektrischen Versorgungseinrichtungen (17; 18; 19) abzugebenden Leistungen vorgibt.

13. Optische Anordnung nach Anspruch 12, **dadurch gekennzeichnet, daß** die Heizstromsteuerschaltung (20, 21) in Signalverbindung mit einem die Abbildungseigenschaften des optischen Elements (4) und/oder der optischen Anordnung messenden Sensor (22) steht und die Vorgabe der an die elektrischen Versorgungseinrichtungen (17, 18, 19) abzugebenden Leistungen in Abhängigkeit vom Meßergebnis des Sensors (22) erfolgt.

14. Optische Anordnung nach Anspruch 13, **dadurch gekennzeichnet, daß** der Sensor (22) ein positionsempfindlicher Sensor ist, der in einer Bildebene des optischen Elements (4) und/oder der optischen Anordnung angeordnet ist.

15. Optische Anordnung nach Anspruch 14, **dadurch gekennzeichnet, daß** der positionsempfindliche Sensor (22) ein CCD-Detektor ist.

16. Optische Anordnung nach einem der vorhergehenden Ansprüche, wobei die Optische Anordnung eine Projections-Belichtungsanlage der Mikrolithographie ist.

17. Optische Anordnung nach Anspruch 16, wobei die Projektions-Belichtungsanlage ein schlitzförmiges Bildfeld oder eine nicht rotationssymmetrische Beleuchtung aufweist.

## Claims

1. Optical arrangement comprising a light source, which emits radiation, a refractive optical element, which is heated by being acted upon in a rotationally non-symmetrical manner by the radiation, at least one electric heating element coupled to the optical element, and a heating current source (17 to 19),
**characterized in that**
the heating element comprises: a resistance heating coating, which is carried by the optical element (4) and which is substantially optically transparent in the region of the surface (3) of the optical element (4) acted upon by the radiation of the light source and comprises a plurality of parallel, electrically mutually insulated coating strips (5 to 10).

2. Optical arrangement according to claim 1, **characterized in that** the coating strips (5 to 10) form a layer which substantially covers the optical element (4) particularly in the region surrounding the surface (3) acted upon by the radiation of the light source, wherein only narrow gaps (11) remain between the individual coating strips (5 to 10).

3. Optical arrangement according to claim 1 or 2, wherein the coating strips (5 to 10) carry an anti-reflecting coating (23) at the side remote from the optical element (4).

4. Optical arrangement according to claim 3, **characterized in that** the anti-reflecting coating (23) is a continuous coating on the optical element (4).

5. Optical arrangement according to any of the preceding claims, **characterized in that** the coating strips (5 to 10) are made of a material, which in the region of the wavelength of the radiation has substantially the same refractive index as the material of the optical element (4).

6. Optical arrangement according to any of the preceding claims, **characterized in that** at least two coating strips (5 to 10) have electrical resistances per unit length which differ from one another.

7. Optical arrangement according to any of the preceding claims, **characterized in that** the coating strips (7, 8) comprise a plurality of zones (14, 15, 16) of differing electrical resistance per unit length.

8. Optical arrangement according to claim 7, **characterized in that** a continuous change of the electrical resistance per unit length is effected between the zones (14, 15, 16) along the coating strips (7, 8).

9. Optical arrangement according to one of the preceding claims, **characterized in that** the coating strips (5 to 10) are disposed mirror-symmetrically relative to a meridional plane of symmetry (12), which lies parallel to the coating strips (5 to 10).

10. Optical arrangement according to claim 9, **characterized in that** the coating strips (7, 8; 6, 9; 5, 10) associated mirror-symmetrically with one another as a result of the meridional plane of symmetry (12) have identical electrical resistances.

11. Optical arrangement according to any of the preceding claims, **characterized in that** the heating current source comprises at least two electric supply devices (17 to 19) and that the coating strips (7, 8; 6, 9; 5, 10) associated mirror-symmetrically with one another as a result of the meridional plane of symmetry (12) are heated by the same electric supply device (17; 18; 19).

12. Optical arrangement according to any of the preceding claims, **characterized in that** the heating current source (17 to 19) has a communication link to a heating current control circuit (20), which preselects the outputs to be delivered by the electric supply devices (17; 18; 19).

13. Optical arrangement according to claim 12, **characterized in that** the heating current control circuit (20, 21) has a communication link to a sensor (22), which measures the imaging properties of the optical element (4) and/or optical arrangement, and the preselection of the outputs to be delivered by the electric supply devices (17, 18, 19) is effected in dependence upon the measurement result of the sensor (22).

14. Optical arrangement according to claim 13, **characterized in that** the sensor (22) is a position-sensitive sensor, which is disposed in a focal plane of the optical element (4) and/or optical arrangement.

15. Optical arrangement according to claim 14, **characterized in that** the position-sensitive sensor (22) is a CCD detector.

16. Optical arrangement according to any of the preceding claims, wherein the optical arrangement is a microlithographic projection exposure apparatus.

17. Optical arrangement according to claim 16, wherein the microlithographic projection exposure apparatus has a slot-shaped image field or rotationally non-symmetrical illumination.

## Revendications

1. Système optique comprenant une source de lumière, qui émet un rayonnement, un élément optique réfractif, qui est chauffé avec le rayonnement par une sollicitation non à symétrie de révolution, et au moins un élément chauffant électrique couplé à l'élément optique, ainsi qu'une source de courant de chauffage (17 à 19),
**caractérisé en ce que**
l'élément chauffant comporte : un revêtement chauffant par effet Joule porté par l'élément optique (4), lequel revêtement est sensiblement transparent de manière optique dans la zone de la surface (3) de l'élément optique (4) sollicitée par le rayonnement de la source de lumière et comprend plusieurs bandes de revêtement (5 à 10) disposées parallèlement, électriquement isolées les unes des autres.

2. Système optique selon la revendication 1, **caractérisé en ce que** les bandes de revêtement (5 à 10) forment une couche recouvrant sensiblement l'élément optique (4), en particulier dans la zone environnante de la surface (3) sollicitée par le rayonnement de la source de lumière, seuls d'étroits espaces intermédiaires (11) restant entre les bandes de revêtement individuelles (5 à 10).

3. Système optique selon la revendication 1 ou 2, **caractérisé en ce que** les bandes de revêtement (5 à 10) portent sur leur face opposée à l'élément optique (4) une couche antireflets (23).

4. Système optique selon la revendication 3, **caractérisé en ce que** la couche antireflets (23) est une couche continue sur l'élément optique (4).

5. Système optique selon l'une quelconque des revendications précédentes, **caractérisé en ce que** les bandes de revêtement (5 à 10) sont fabriquées à partir d'un matériau qui présente dans la zone de la longueur d'onde du rayonnement essentiellement le même indice de réfraction que le matériau de l'élément optique (4).

6. Système optique selon l'une quelconque des revendications précédentes, **caractérisé en ce qu'**au moins deux bandes de revêtement (5 à 10) comprennent par unité de longueur des résistances électriques différentes les unes des autres.

7. Système optique selon l'une quelconque des revendications précédentes, **caractérisé en ce que** les bandes de revêtement (7, 8) sont constituées par unité de longueur de plusieurs zones (14, 15, 16) dotées d'une résistance électrique différente.

8. système optique selon la revendication 7, **caractérisé en ce qu'**une transition continue de la résistance électrique par unité de longueur s'effectue entre les zones (14, 15, 16) le long des bandes de revêtement (7, 8).

9. Système optique selon l'une quelconque des revendications précédentes, **caractérisé en ce que** les bandes de revêtement (5 à 10) sont disposées à symétrie inversée par rapport à un plan de symétrie tangentiel (12), qui se situe parallèlement aux bandes de revêtement (5 à 10).

10. Système optique selon la revendication 9, **caractérisé en ce que** les bandes de revêtement (7, 8 ; 6, 9 ; 5, 10) associées les unes aux autres à symétrie inversée à travers le plan de symétrie tangentiel (12) comprennent des résistances électriques identiques.

11. Système optique selon l'une quelconque des revendications précédentes, **caractérisé en ce que** la source de courant de chauffage présente au moins deux dispositifs d'alimentation électriques (17 à 19) et **en ce que** les bandes de revêtement (7, 8 ; 6, 9 ; 5, 10) associées les unes aux autres par symétrie inversée à travers le plan de symétrie tangentiel (12) sont chauffées par le même dispositif d'alimentation électrique (17 ; 18 ; 19).

12. Système optique selon l'une quelconque des revendications précédentes, **caractérisé en ce que** la source de courant de chauffage (17 à 19) est en relation de signalisation avec un circuit de commande de courant de chauffage (20), qui prédéfinit les puissances destinées à être délivrées par les dispositifs d'alimentation électriques (17 ; 18 ; 19).

13. Système optique selon la revendication 12, **caractérisé en ce que** le circuit de commande de courant de chauffage (20, 21) est en relation de signalisation avec un capteur (22) mesurant les propriétés de reproduction de l'élément optique (4) et/ou du système optique et la prédétermination des puissances destinées à être délivrées aux dispositifs d'alimentation électriques (17, 18, 19) s'effectue en fonction du résultat de mesure du capteur (22).

14. Système optique selon la revendication 13, **caractérisé en ce que** le capteur (22) est un capteur sensible à la position, qui est disposé dans un plan focal de l'élément optique (4) et/ou du système optique.

15. Système optique selon la revendication 14, **caractérisé en ce que** le capteur sensible à la position (22) est un détecteur CCD.

16. Système optique selon l'une quelconque des revendications précédentes, le système optique étant une installation d'éclairage à projection de la microlithographie.

17. Système optique selon la revendication 16, l'installation d'éclairage à projection présentant un champ d'image en forme de fente ou un éclairage qui n'est pas à symétrie de révolution.
